# EUROPEAN PATENT SPECIFICATION

(11) **EP 4 316 202 B1**
(45) Date of publication and mention of the grant of the patent: **09.12.2026**
(21) Application number: 22718373.8
(22) Date of filing: 28.03.2022
(51) Int. Cl.: H05B 1/02, H05K 7/20

(54) **SOLID STATE RELAY MODULE HEATING SYSTEM AND METHODS**
FESTKÖRPERRELAISMODULHEIZSYSTEM UND -VERFAHREN
SYSTÈME ET PROCÉDÉS DE CHAUFFAGE DE MODULE DE RELAIS À SEMI-CONDUCTEURS

(30) Priority: 26.03.2021 US 202163166541 P
(43) Date of publication of application: 07.02.2024
(73) Proprietor: Chemelex Europe GmbH, 8200 Schaffhausen (CH)
(72) Inventor: CICHOCKI, Arkadiusz, 50-540 Wroclaw (PL); KOZIOL, Artur, 28-200 Dzierzoniow (PL); TUCHORSKI, Wojciech, 8200 Dzierzoniow (PL)
(74) Representative: Barker Brettell LLP
(86) International application number: PCT/US2022/022210
(87) International publication number: WO 2022/204603

(56) References cited:
- WO-A1-2022/136663
- CN-B- 104 166 414
- CN-U- 203 984 828
- US-A1- 2011 273 844
- US-A1- 2020 267 870

## Description

### CROSS-REFERENCE TO RELATED APPLICATIONS

The application claims the benefit of U.S. Provisional Patent Application 63/166,541 filed March 26, 2021, and entitled "Solid State Relay Module Heating System and Method".

### BACKGROUND

Electronics modules such as temperature controllers can be housed in or on weatherproof enclosures and used in outdoor environments. In extreme environments, these environments may reach temperatures as low as -55 degrees Celsius (°C) or even colder. Electronic components however, are usually only rated for operation in temperatures of -40°C or warmer, and may malfunction or even suffer permanent damage if operated at excessively low temperatures. Thus, to enable operation at very low temperatures, some enclosures may require electric heater assemblies to preheat the electronics to a safe operating temperature.

### SUMMARY

Some embodiments of the invention provide a solid state relay module configured to be coupled to an electronics enclosure. The solid state relay module includes a body with a first side and an opposite second side and two cable channels extending from the first side of the body. Each of the two cable channels is sized to receive a heating cable. The solid state relay module also includes a solid state relay platform defined between the two cable channels, where the solid state relay platform is sized to receive a solid state relay. The solid state relay module further includes a heat sink extending from the second side of the body.

Some embodiments of the invention provide a solid state relay module configured to be coupled to an electronics enclosure, the solid state relay module. The solid state relay module includes a body with a first side and an opposite second side and a cable channel extending from the first side of the body. The cable channel sized to receive a heating cable. The solid state relay module also includes a solid state relay platform positioned adjacent to the cable channel, where the solid state relay platform sized to receive a solid state relay. The solid state relay module further includes a heat sink extending from the second side of the body.

Some embodiments of the invention provide a system comprising an electronics enclosure, a solid state relay module, and a control system. The solid state relay module is configured to be coupled to the electronics enclosure and includes a solid state relay and a heating cable. The control system is configured to receive a first signal representing a temperature within the electronics enclosure, operate the solid state relay when the temperature within the electronics enclosure is at or above a first temperature, and operate the heating cable when the temperature within the electronics enclosure is below a second temperature.

### DESCRIPTION OF THE DRAWINGS

FIG. 1 is a front, internal view of an electronics enclosure.
FIG. 2 is a front view of an electronics enclosure including a plurality of SSR modules according to some embodiments.
FIG. 3 is a side view of the electronics enclosure of FIG. 2.
FIG. 4 is a front isometric view of an SSR module according to some embodiments.
FIG. 5 is a rear isometric view of the SSR module of FIG. 4.
FIG. 6 is a front view of the SSR module of FIG. 4.
FIG. 7 is a side view of the SSR module of FIG. 4.
FIG. 8 is a top view of the SSR module of FIG. 4.
FIG. 9 is a top view of a body of the SSR module of FIG. 4.
FIG. 10 is an internal isometric view of the SSR module of FIG. 4 coupled to the electronics enclosure of FIG. 2.
FIG. 11 is an isometric exploded view of the SSR module of FIG. 4.
FIG. 12 is another isometric exploded view of the SSR module of FIG. 4.
FIG. 13 is a partial, rear isometric view of the SSR module of FIG. 4.
FIG. 14 is an isometric exploded view of an SSR module according to some embodiments.
FIG. 15 is a schematic view of a system according to some embodiments.

### DETAILED DESCRIPTION

The invention is defined by the claims. In particular, the invention is defined as a solid state relay module (22) configured to be coupled to an electronics enclosure (20) and to receive a solid state relay (14), the solid state relay module (22) comprising: a base (40) including a first side (46) and an opposite second side (48), the base (40) configured to be coupled to the electronics enclosure (20); a cable channel (42) extending from the first side (46) of the base (40), the cable channel (42) sized to receive a heating cable (38); a solid state relay platform (26) positioned on the base (40) adjacent to the cable channel (42), the solid state relay platform (26) sized to receive a solid state relay (14); a heat sink (28) extending from the second side (48) of the base (40); and a cover (30) coupled to the base (40) around the heat sink (28).

Furthermore, the invention is defined as a system (90) comprising: an electronics enclosure (20); the solid state relay module (22) of claim 1, the solid state relay module (22) including the solid state relay (14) and the heating cable (38); and a control system configured to: receive a first signal representing a temperature within the electronics enclosure, operate the solid state relay (14) when the temperature within the electronics enclosure (20) is at or above a first temperature, and operate the heating cable (38) when the temperature within the electronics enclosure (20) is below a second temperature.

Numeric ranges disclosed herein are inclusive of their endpoints. For example, a numeric range of between 1 and 10 includes the values 1 and 10. When a series of numeric ranges are disclosed for a given value, the present disclosure expressly contemplates ranges including all combinations of the upper and lower bounds of those ranges. For example, a numeric range of between 1 and 10 or between 2 and 9 is intended to include the numeric ranges of between 1 and 9 and between 2 and 10.

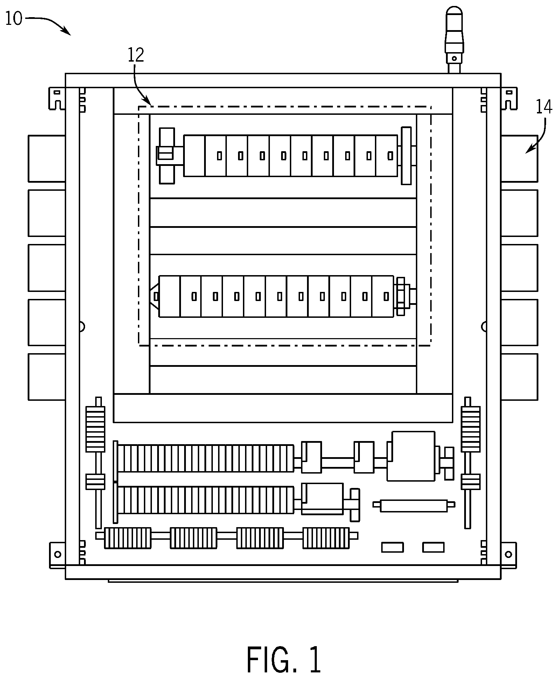

FIG. 1 illustrates an electronics enclosure 10 configured to mount electronic equipment. The enclosure 10 can support electronics 12 internally, such as internally mounted temperature controllers, wire terminals, or other electronics, as well as support electronics externally, such as externally mounted solid state relays (SSRs) 14. That is, the SSRs 14 may be mounted along the enclosure 10 to interface with an outside of the enclosure 10. In some applications, this type of enclosure 10 may be used in certain environments, such as arctic environments or oil platform environments. These environments often encounter extreme temperatures (e.g., below -40 °C) that may cause malfunctions in electronic equipment 12, 14, supported by the enclosure 10. That is, such electronics 12, 14 may not be rated to withstand such cold temperatures. Furthermore, in warmer temperatures, heat generated by the SSRs 14 may become trapped within the electronics enclosure 10, negatively affecting other electronics 12 therein. As further described below, some embodiments provide one or more SSR modules that are configured as all-weather modules capable of heating or cooling SSRs 14, as necessary.

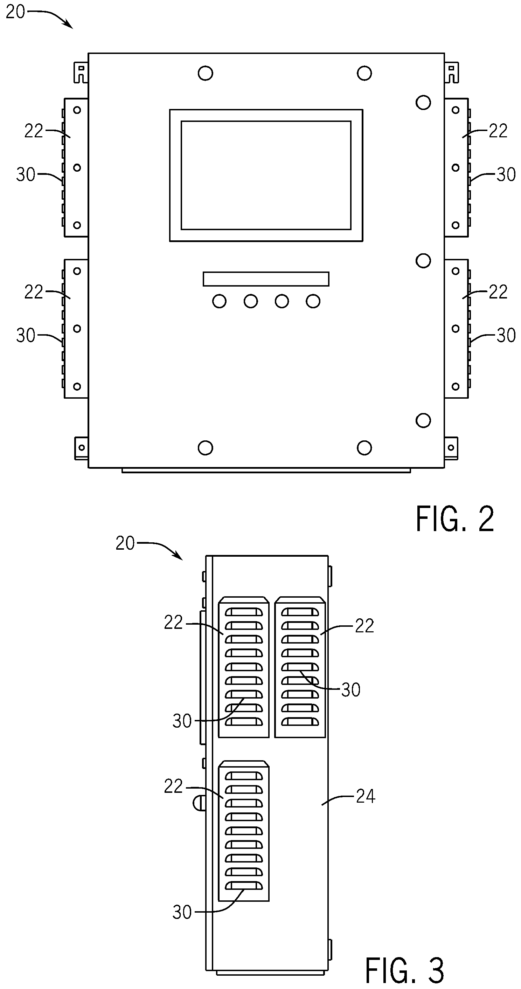

For example, FIGS. 2 and 3 illustrate an electronics enclosure 20 that can include one or more SSR modules 22, according to some embodiments. Each SSR module 22 can be coupled to a wall 24 of the electronics enclosure 20 and can receive one or more SSRs 14, such as one, two, three, or more SSRs 14. For example, in some applications, the electronics enclosure 20 can include electronics for controlling and/or monitoring external heat trace cables. Each SSR module 22 can accommodate three SSRs 14 required for switching of three-phase power for such heat trace cables.

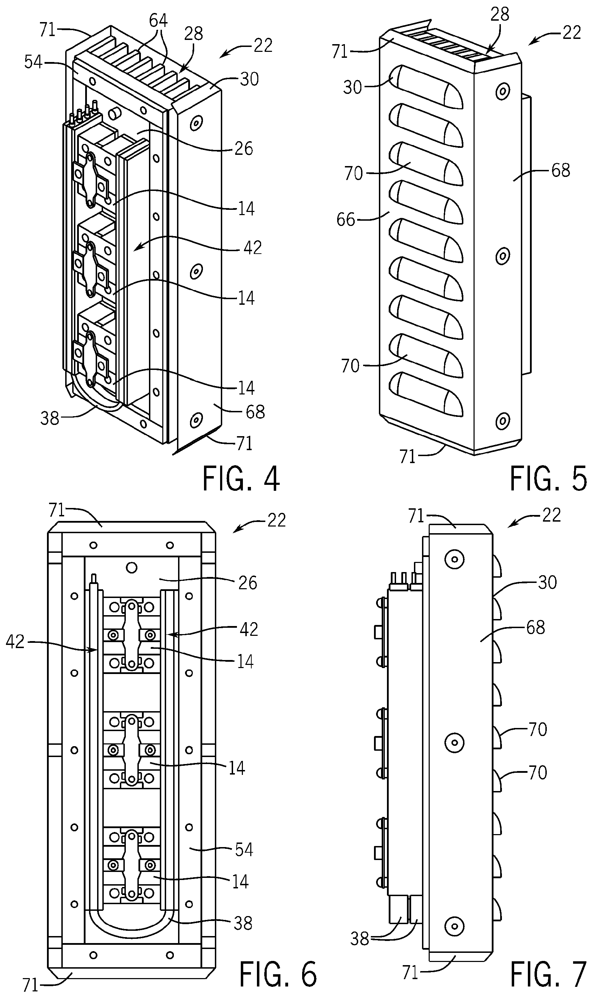

According to some embodiments, as shown in FIGS. 4-12, each SSR module 22 can include an SSR platform 26, a heat sink 28, and a cover 30. Furthermore, each SSR module 22 can include one or more SSRs 14, one or more thermal pads 32, one or more mounting plates 34, and fasteners 36. Additionally, each SSR module 22 can include one or more heating cables 38 configured to provide localized heating to the SSRs 14 on the SSR platform 26. Generally, the SSR module 22 can be coupled to the electronics enclosure 20. For example, the SSR module 22 can be mounted within the electronics enclosure 20 so that the SSRs 14 extend into the electronics enclosure 20 and interfaced to an outside of the electronics enclosure 20, so that at least the heat sink 28 extends out of the electronics enclosure 20 as a means to release heat generated by the SSRs 14 out of the electronics enclosure 20, and the cover 30 is generally positioned outside of the electronics enclosure 20 to cover the heat sink 28.

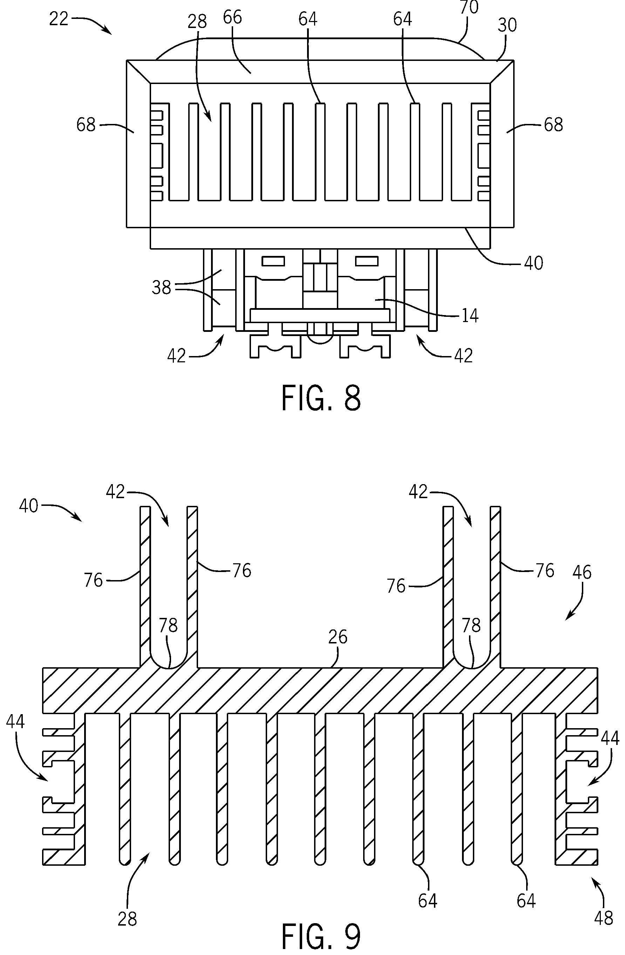

In some embodiments, at least the SSR platform 26 and the heat sink 28 can be formed integrally as a single, one-piece base 40, as shown in FIG. 9. That is, as shown in FIG. 9, the base 40 can include the SSR platform 26 and the heat sink 28, as well as cable channels 42, and, optionally, one or more cover mounting sections 44. The SSR platform 26 can be positioned between two parallel cable channels 42 on a first side 46 of the base 40, and the heat sink 28 and the cover mounting sections 44 can be positioned on a second, opposite side 48 of the base 40.

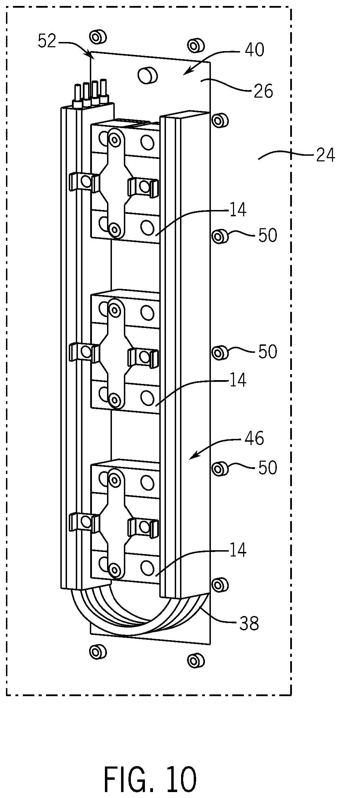

The base 40 can be coupled to the electronics enclosure 20. More specifically, in some embodiments, as shown in FIG. 10, the first side 46 of the base 40 can be mounted to a wall 24 of the electronics enclosure 20 (e.g., an outside of the wall 24), via fasteners 50, so that the cable channels 42 extend into the electronics enclosure 20 via a hole 52 in the wall 24. Additionally, in some embodiments, a gasket 54, such as a silicone gasket, as shown in FIGS. 4, 6, and 11, can be positioned between the first side 46 and the wall 24 to help seal an interior of the electronics enclosure 20. In some embodiments, the base 40 may be formed of a material suitable for heat transfer, such as aluminum or another metal.

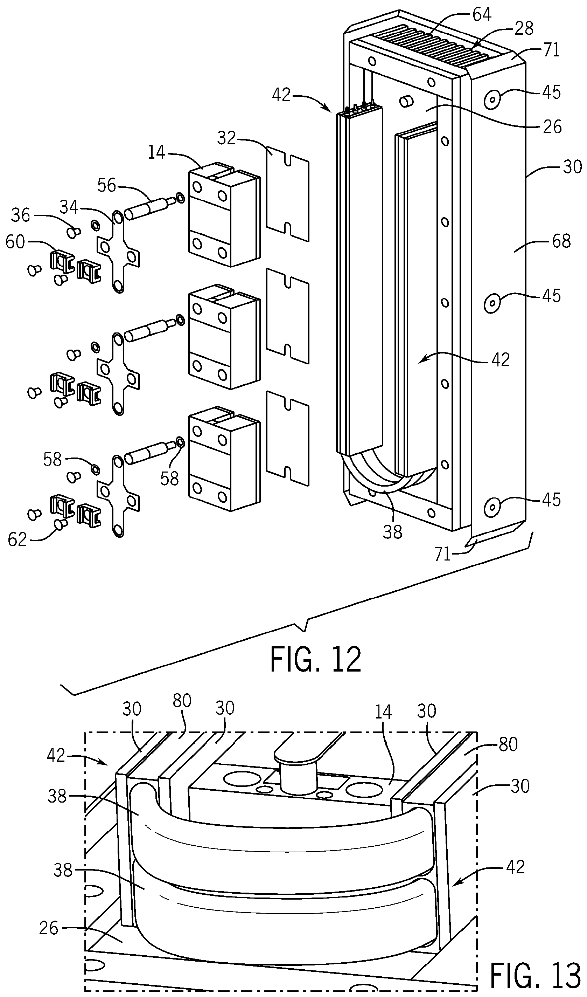

Referring to components of the base 40, the SSR platform 26 can be sized to receive the one or more SSRs 14. For example, as shown in FIG. 9, the SSR platform 26 can be positioned between two parallel cable channels 42. In some embodiments, the cable channels 42 can be spaced apart a distance substantially equal to a width of an SSR 14 so that SSRs 14 received on the SSR platform 26 are snuggly fit between the channels 42. Furthermore, as shown in FIG. 12, for each respective SSR 14, a thermal pad 32 may be positioned against the SSR platform 26, the SSR 14 can be placed against the thermal pad 32, and a mounting plate 34, the thermal pad 32, and the SSR 14 can be coupled to the SSR platform 26 via standoffs 56, washers 58, and the fasteners 36. Furthermore, in some embodiments, as shown in FIG. 12, one or more cable tie bases 60 can be coupled to the mounting plate 34 via fasteners 62.

In such an arrangement, heat generated by the SSRs 14 can travel from the SSRs 14 to the thermal pads 32, to the SSR platform 26. Furthermore, as noted above, the heat sink 28 can be positioned along the opposite side 48 of the base 40 as the SSR platform 26. More specifically, as shown in FIG. 9, the heat sink 28 can include a plurality of fins 64 extending away from the SSR platform 26. Thus, heat generated by each SSR 14 can travel through the thermal pad 32 to the SSR platform 26, to be released to the outside environment through the fins 64. In some embodiments, the fins 64 can extend an entire length of the base 40. However, in other embodiments, the fins 64 may extend a portion or portions of the entire length of the base 40.

Accordingly, the heat sink 28 can act to release heat generated by the SSRs 14 outside of the electronics enclosure 20, for example, so that such heat is not trapped within the electronics enclosure 20. Furthermore, the cover 30 can act to cover the heat sink 28 to generally help protect the heat sink 28 from outside elements, while still allowing for efficient air flow across the fins 64 for heat release when needed. However, in cold conditions, the cover 30 can also protect the heat sink 28 from, for example, cold winds. For example, in some embodiments, the cover 30 can include a front 66 and two ends 68 extending substantially perpendicular from the front 66. The cover 30 can have a length substantially equal to a length of the base 40. As shown in FIGS. 5, 7, 8, and 11, the front 66 and/or the ends 68 can include one or more vents 70 (such as partially covered openings) so that the cover 30 permits air flow and, thus, heat release, through the vents 70. In some embodiments, the two ends 68 function as a wind cover for balancing heat capture under cold, windy conditions with heat release via the fins 64 of the heat sink 28.

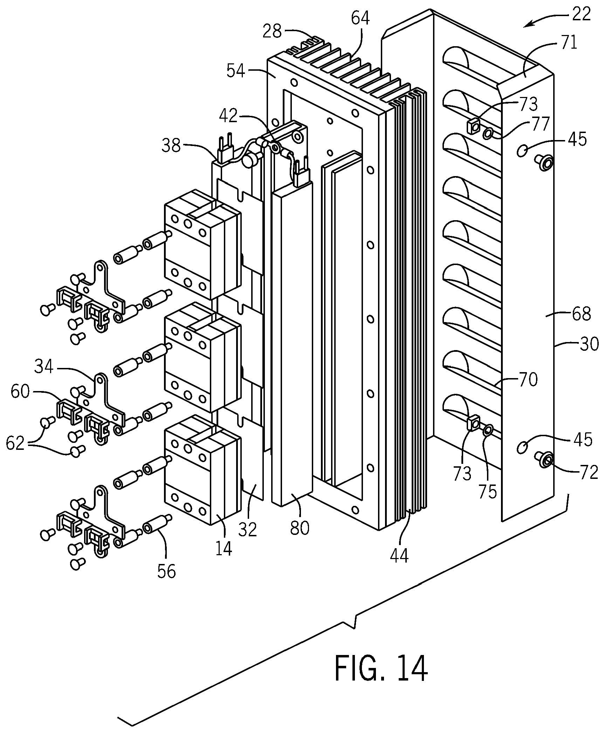

Additionally, in some embodiments, a top and/or bottom of the cover 30 may be substantially open to permit air flow past the fins 64 of the heat sink 28. For example, in some embodiments, as shown in FIGS. 4-7, 11, and 12, the cover 30 can include angled top and bottom edges 71 that extend into an open top and an open bottom. In some embodiments, as shown in FIG. 14, the cover 30 can include angled top edges 71 extending into an open top, and a completely open bottom (e.g., with no angled edges extending therein). In yet other embodiments, the cover 30 may include a top wall and/or a bottom wall (not shown), or may include angled bottom edges 71 extending into an open bottom, and a completely open top (e.g., with no angled edges extending therein).

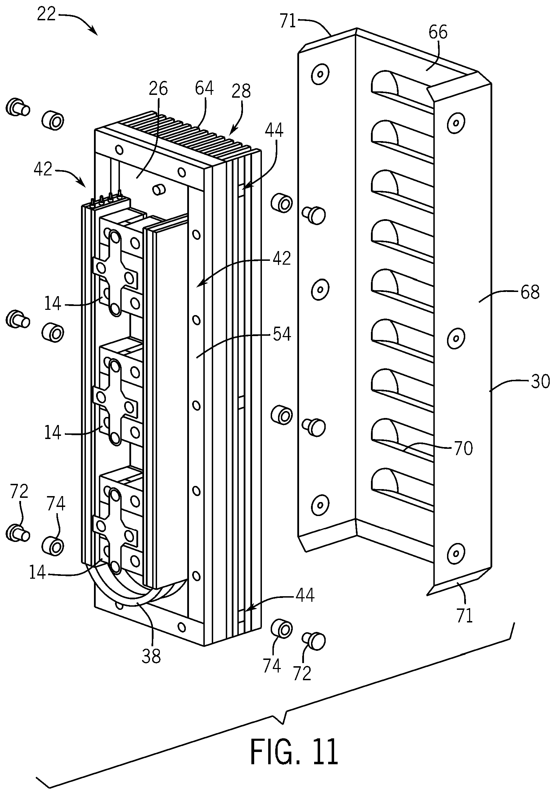

In some embodiments, the cover 30 can be coupled to the base 40, for example, at the cover mounting sections 44 of the base 40. For example, as shown in FIGS. 9 and 11, the cover mounting sections 44 can be located at the outermost fins 64 and extend a length of the base 40. The cover 30 can be coupled to the base 40 at the cover mounting sections 44 via fasteners 72 and insulating spacers 74. For example, the cover 30 can include one or more cover mounting holes 45 on each side, through which a fastener 72 can extend, to be coupled to a spacer 74 within the cover mounting section 44. The insulating spacers 74 can help prevent or minimize direct heat transfer between the cover 30 and the base 40. In some embodiments, as shown in FIG. 14, the cover 30 can be coupled to the base at the cover mounting sections 44 via fasteners 72, nuts 73, and washers 75. Also, at one of the cover mounting sections 44, a washer tooth 77 can be used and act as a cover grounding point.

In some embodiments, as shown in FIGS. 4-7, 11, and 12, the cover 30 can include three cover mounting holes 45 along each side. In other embodiments, as shown in FIG. 14, the cover 30 can include two cover mounting holes 45 along each side. In yet other embodiments, the cover 30 can include one, four, or more cover mounting holes 45 along each side, or along the front, top, or bottom. Additionally, in some embodiments, the cover 30 can comprise 304 stainless steel or a similar all-weather resistant material.

While the SSR module 22 acts to release heat generated by the SSRs 14, in some conditions, the SSR module 22 must be heated. That is, in extreme environments in which electronic enclosures 20 may be operated, temperatures may reach as low as -55 degrees Celsius (°C) or even colder. Electronic components such as SSRs 14, however, are often only rated for operation in temperatures of, for example, -40°C or warmer, and may malfunction or even suffer permanent damage if operated at excessively low temperatures. Thus, to enable operation at very low temperatures, the SSR modules 22 may be configured to preheat the SSRs 14 to a "safe" operating temperature (such as at least to a baseline operating temperature). Accordingly, in some embodiments, during operation, a controller and/or additional components (not shown) can operate the heating cable(s) 38 and/or the SSRs 14 based on a sensed temperature within the electronics enclosure 20, as further described below.

As noted above, the SSR module 22 and, more specifically, the base 40, can include one or more channels 42 configured to receive a portion of a heating cable 38 for locally heating an SSR 14 mounted thereon. Referring back to FIG. 9, in some embodiments, each cable channel 42 may be defined by parallel channel walls 76 extending from a channel bottom 78. The channel walls 76 may be formed of a material suitable for heat transfer, such as aluminum or another metal. As the SSR platform 26 can be positioned between the cable channels 42, heat generated by heating cables 38 within the channels 42 can help heat the SSRs 14 positioned therebetween. Alternatively, in some embodiments, the SSR module 22 may only include a single cable channel 42 positioned adjacent the SSR platform 26.

As shown in FIGS. 4, 6, 11, and 12, the cable channels 42 can run at least a portion of a length of the base 40. Furthermore, as shown in FIGS. 4, 6, 11, 12, and 13, one or more heating cables 38 can be routed through a first of the cable channels 42, bent around, and routed through a second of the cable channels 42. In some embodiments, the cable channels 42 can include a height sufficient to accommodate two heating cables 38 stacked over one another. In other embodiments, the cable channels 42 can be sized to accommodate a single heating cable 38, more than two heating cables 38, or multiple heating cables 38 arranged side-by-side.

In order to transfer heat from the heating cable 38 to the SSR module 14, a heating cable 38 can be potted in a respective channel 42 with a heat transfer medium, such as a two-component polyurethane (PU) compound 80 or another suitable compound, as shown in FIG. 13. For example, the heating cable 38 can positioned within the channel 42 (i.e., between the channel walls 76) and a potting compound (such as a PU compound 80) is poured into the channel 42 over the heating cable 38, then left to cure.

Alternatively, in some embodiments, the heating cables 38 can be pre-encapsulated with the potting compound (e.g., PU compound 80) and then inserted into a respective channel 42, as shown in FIG. 13, thus eliminating the need for in-channel potting and curing. For example, the heating cables 38 can be pre-encapsulated according to the methods described in U.S. Application No. 17,556,172, filed December 20, 2021, the entire contents of which is incorporated herein by reference. For example, one or more lengths of a heating cable 38 is encapsulated with PU compound 80 and cured, forming a PU block. The PU block can be sized to correlate with dimensions of the channel 42. More specifically, at least a width of the PU block is sized to be slightly larger than a width of the channel 42 so that, when the PU block is pushed into the channel 42, the PU block is compressed into the channel 42 to create a press-fit coupling. This tight fit can provide constant contact between the PU block and walls of the channel 42 for optimal heat transfer from the heating cable 38 to the channel walls 76 through the PU block. Additionally, in some embodiments, a length of the PU block may be substantially equivalent to a length of the channel 42, and a height of the PU block may be substantially equivalent to or larger than a height of the channel 42 such that an installed PU block can extend out of the channel 42.

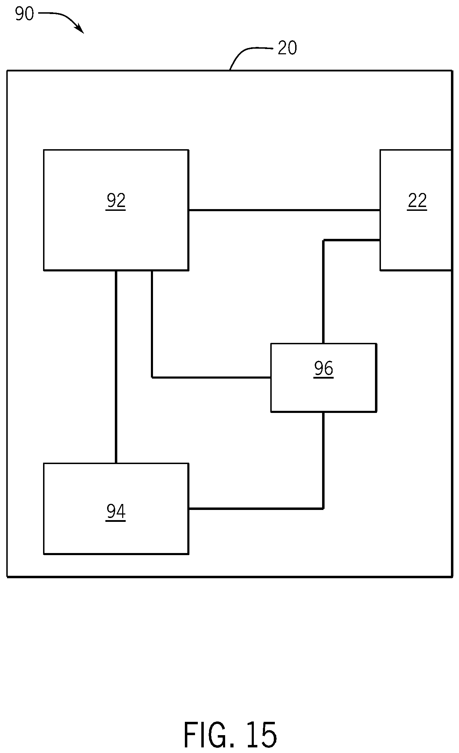

As noted above, in some embodiments, the heating cable(s) 38 and/or the SSRs 14 can be powered based on a sensed temperature within the electronics enclosure 20. For example, FIG. 15 illustrates a system 90 including the electronics enclosure 20, one or more SSR modules 22, a controller 92, a power source 94, and/or a mechanical thermostat 96. In some embodiments, the controller 92 may be located within the electronics enclosure 20, externally from the electronics enclosure 20, or within the SSR module 22, and can receive a temperature signal. Also, in some embodiments, the power source 94 may be located within the electronics enclosure 20, or may be a power source connection 94 to an external power source.

In some embodiments, the SSRs 14 within the SSR module 22 can be coupled to both the controller 92 and the mechanical thermostat 96. Furthermore, in some embodiments, the mechanical thermostat 96 can be coupled to the controller 92. In some embodiments, the SSRs 14 may be controlled by the controller 92, but also coupled to the power source 94 via the mechanical thermostat 96 within the electronics enclosure 20, wherein the mechanical thermostat 96 only connects power from the power source to the SSRs 14 when a baseline temperature is met. As such, the controller 92 and the mechanical thermostat 96 can be considered part of a control system configured to control the SSR module 22. Additionally, the controller 92 can be coupled to the heating cables 38 within the SSR module 22 and can operate the heating cables 38 when a sensed temperature within the electronics enclosure 20 or outside the electronics enclosure 20 is at or below a predetermined threshold. In some embodiments, the predetermined threshold and the baseline temperature are the same temperature. However, in other embodiments, the predetermined threshold and the baseline temperature are different temperatures. The sensed temperature may be a temperature signal received by the controller 92, for example, as a local temperature from the thermostat 96, a local ambient temperature from an external interface with weather data, or another signal.

Accordingly, within the system 90, the SSRs 14 within the SSR modules 22 are configured to operate at or above a baseline temperature, and the heating cables 38 within the SSR modules 22 are configured to operate at or below a predetermined temperature threshold (e.g., in order to bring the temperature of the SSRs 14 to or above the baseline temperature so that they can be operated). Additionally, it should be noted that, while the examples described herein generally refer to heating cables 38, such examples may also apply to cartridge heaters.

In light of the above, some embodiments provide an SSR module configured to heat or cool solid state relays of an electronics enclosure depending on outside conditions. That is, the SSR module is configured to provide sufficient heat dissipation from SSRs when needed, as well as provide localized heating for bringing SSRs to a suitable operating temperature when needed. Both heating and cooling can be accomplished through a single body, which may accommodate heating cables adjacent the SSRs as well as cooling fins of a heat sink adjacent the SSRs. Furthermore, a wind cover balances heat capture under cold, windy conditions with heat release via the cooling fins of the heat sink under other conditions when needed.

It will be appreciated by those skilled in the art that while the invention has been described above in connection with particular embodiments and examples, the invention is not necessarily so limited, and that numerous other embodiments, examples, uses, modifications and departures from the embodiments, examples and uses are intended to be encompassed by the claims attached hereto. Various features and advantages of the invention are set forth in the following claims.

## Claims

1. A solid state relay module (22) configured to be coupled to an electronics enclosure (20) and to receive a solid state relay (14), the solid state relay module (22) comprising:
a base (40) including a first side (46) and an opposite second side (48), the base (40) configured to be coupled to the electronics enclosure (20);
a cable channel (42) extending from the first side (46) of the base (40), the cable channel (42) sized to receive a heating cable (38);
a heat sink (28) extending from the second side (48) of the base (40);
and **characterized by** a solid state relay platform (26) positioned on the base (40) adjacent to the cable channel (42), the solid state relay platform (26) sized to receive a solid state relay (14);
and by a cover (30) coupled to the base (40) around the heat sink (28).

2. The solid state relay module (22) of claim 1, wherein the base (40) is configured to be coupled to a wall (24) of the electronics enclosure (20) so that the cable channel (42) extends into the electronics enclosure (20) and the heat sink (28) extends out of the electronics enclosure (20); and, optionally or preferably,
further comprising a gasket (43) to be positioned between the base (40) and the wall (24).

3. The solid state relay module (22) of claim 1, wherein the solid state relay platform (26) and the heat sink (28) are formed integrally as a single base (40).

4. A system (90) comprising:
an electronics enclosure (20);
the solid state relay module (22) of claim 1, the solid state relay module (22) including the solid state relay (14) and the heating cable (38); and
a control system configured to:
receive a first signal representing a temperature within the electronics enclosure,
operate the solid state relay (14) when the temperature within the electronics enclosure (20) is at or above a first temperature, and
operate the heating cable (38) when the temperature within the electronics enclosure (20) is below a second temperature.

5. The system of claim 4, wherein the control system includes a controller (92) and a mechanical thermostat (96), wherein the solid state relay (14) is coupled to a power source (94) via the mechanical thermostat (96); and, optionally or preferably,
wherein the mechanical thermostat (96) connects power from the power source (94) to the solid state relay (14) when the first temperature is reached.

6. The system of claim 4, wherein the control system is located within the electronics enclosure (20).

7. The system of claim 4, wherein the first temperature and the second temperature are equal.

8. The solid state relay module (22) of claim **1,** wherein the cable channel (42) includes
two cable channels (42) extending from the first side (46) of the base (40), each of the two cable channels (42) sized to receive a heating cable (38); and wherein
the solid state relay platform (26) is defined on the base (40) between the two cable channels (42).

9. The solid state relay module (22) of claim 8, wherein the cover (30) includes a vented opening (70), or wherein the cover (30) is coupled to the base (40) via fasteners (72) and insulated spacers 74.

10. The solid state relay module (22) of claim 8, wherein the cover (30) includes a front (66) and two ends (68) extending perpendicular from the front (66); and, optionally or preferably,
wherein the cover (30) includes an open top and an open bottom.

11. The solid state relay module (22) of claim 8, wherein the heat sink (28) comprises a plurality of fins (64) extending from the second side (48) of the base (40).

12. The solid state relay module (22) of claim 8, wherein a single heating cable (38) is routed through both of the two cable channels (42).

13. The solid state relay module (22) of claim 8, wherein the base (40) is configured to be coupled to a wall (24) of the electronics enclosure (20) so that the two cable channels (42) extend into the electronics enclosure (20) and the heat sink (28) extends out of the electronics enclosure (20); and, optionally or preferably,
further comprising a gasket (54) to be positioned between the base (40) and the wall (24).

14. The solid state relay module (22) of claim 8, wherein the heating cable (38) is configured to heat the solid state relay (14) to a baseline operating temperature.

## Patentansprüche

1. Festkörperrelaismodul (22), das dazu konfiguriert ist, an ein Elektronikgehäuse (20) gekoppelt zu werden und ein Festkörperrelais (14) aufzunehmen, wobei das Festkörperrelaismodul (22) Folgendes umfasst:
eine Basis (40), die eine erste Seite (46) und eine gegenüberliegende zweite Seite (48) beinhaltet, wobei die Basis (40) dazu konfiguriert ist, an das Elektronikgehäuse (20) gekoppelt zu werden;
einen Kabelkanal (42), der sich von der ersten Seite (46) der Basis (40) erstreckt, wobei der Kabelkanal (42) bemessen ist, um ein Heizkabel (38) aufzunehmen;
einen Kühlkörper (28), der sich von der zweiten Seite (48) der Basis (40) erstreckt;
und **gekennzeichnet durch** eine Festkörperrelaisplattform (26), die auf der Basis (40) benachbart zu dem Kabelkanal (42) positioniert ist, wobei die Festkörperrelaisplattform (26) bemessen ist, um ein Festkörperrelais (14) aufzunehmen;
und durch eine Abdeckung (30), die um den Kühlkörper (28) an die Basis (40) gekoppelt ist.

2. Festkörperrelaismodul (22) nach Anspruch 1, wobei die Basis (40) dazu konfiguriert ist, an eine Wand (24) des Elektronikgehäuses (20) gekoppelt zu werden, sodass sich der Kabelkanal (42) in das Elektronikgehäuse (20) erstreckt und sich der Kühlkörper (28) aus dem Elektronikgehäuse (20) erstreckt; und optional oder vorzugsweise
ferner umfassend eine Dichtung (43), die zwischen der Basis (40) und der Wand (24) zu positionieren ist.

3. Festkörperrelaismodul (22) nach Anspruch 1, wobei die Festkörperrelaisplattform (26) und der Kühlkörper (28) einstückig als eine einzelne Basis (40) ausgebildet sind.

4. System (90), umfassend:
ein Elektronikgehäuse (20);
das Festkörperrelaismodul (22) nach Anspruch 1, wobei das Festkörperrelaismodul (22) das Festkörperrelais (14) und das Heizkabel (38) beinhaltet; und
ein Steuersystem, das dazu konfiguriert ist:
ein erstes Signal zu empfangen, das eine Temperatur innerhalb des Elektronikgehäuses darstellt,
das Festkörperrelais (14) zu betreiben, wenn die Temperatur innerhalb des Elektronikgehäuses (20) bei oder über einer ersten Temperatur liegt, und
das Heizkabel (38) zu betreiben, wenn die Temperatur innerhalb des Elektronikgehäuses (20) unter einer zweiten Temperatur liegt.

5. System nach Anspruch 4, wobei das Steuersystem eine Steuerung (92) und einen mechanischen Thermostat (96) beinhaltet, wobei das Festkörperrelais (14) über den mechanischen Thermostat (96) an eine Leistungsquelle (94) gekoppelt ist; und optional oder vorzugsweise
wobei der mechanische Thermostat (96) eine Leistung von der Leistungsquelle (94) mit dem Festkörperrelais (14) verbindet, wenn die erste Temperatur erreicht ist.

6. System nach Anspruch 4, wobei sich das Steuersystem innerhalb des Elektronikgehäuses (20) befindet.

7. System nach Anspruch 4, wobei die erste Temperatur und die zweite Temperatur gleich sind.

8. Festkörperrelaismodul (22) nach Anspruch 1, wobei der Kabelkanal (42) Folgendes beinhaltet:
zwei Kabelkanäle (42), die sich von der ersten Seite (46) der Basis (40) erstrecken, wobei jeder der zwei Kabelkanäle (42) bemessen ist, um ein Heizkabel (38) aufzunehmen; und wobei
die Festkörperrelaisplattform (26) auf der Basis (40) zwischen den zwei Kabelkanälen (42) definiert ist.

9. Festkörperrelaismodul (22) nach Anspruch 8, wobei die Abdeckung (30) eine belüftete Öffnung (70) beinhaltet oder wobei die Abdeckung (30) über Befestigungselemente (72) und isolierte Abstandshalter 74 an die Basis (40) gekoppelt ist.

10. Festkörperrelaismodul (22) nach Anspruch 8, wobei die Abdeckung (30) eine Vorderseite (66) und zwei Enden (68), die sich senkrecht von der Vorderseite (66) erstrecken, beinhaltet; und optional oder vorzugsweise
wobei die Abdeckung (30) eine offene Oberseite und eine offene Unterseite beinhaltet.

11. Festkörperrelaismodul (22) nach Anspruch 8, wobei der Kühlkörper (28) eine Mehrzahl von Rippen (64) umfasst, die sich von der zweiten Seite (48) der Basis (40) erstrecken.

12. Festkörperrelaismodul (22) nach Anspruch 8, wobei ein einzelnes Heizkabel (38) durch beide der zwei Kabelkanäle (42) geführt wird.

13. Festkörperrelaismodul (22) nach Anspruch 8, wobei die Basis (40) dazu konfiguriert ist, an eine Wand (24) des Elektronikgehäuses (20) gekoppelt zu werden, sodass sich die zwei Kabelkanäle (42) in das Elektronikgehäuse (20) erstrecken und sich der Kühlkörper (28) aus dem Elektronikgehäuse (20) erstreckt; und optional oder vorzugsweise
ferner umfassend eine Dichtung (54), die zwischen der Basis (40) und der Wand (24) zu positionieren ist.

14. Festkörperrelaismodul (22) nach Anspruch 8, wobei das Heizkabel (38) dazu konfiguriert ist, das Festkörperrelais (14) auf eine Basisbetriebstemperatur zu erhitzen.

## Revendications

1. Module de relais à semi-conducteurs (22) configuré pour le couplage à une enceinte électronique (20) et pour la réception d'un relais à semi-conducteurs (14), le module de relais à semi-conducteurs (22) comprenant :
une base (40) incluant un premier côté (46) et un second côté opposé (48), la base (40) étant configurée pour le couplage à l'enceinte électronique (20) ;
un canal de câble (42) s'étendant à partir du premier côté (46) de la base (40), le canal de câble (42) étant dimensionné pour la réception d'un câble chauffant (38) ;
un dissipateur thermique (28) s'étendant à partir du second côté (48) de la base (40) ;
et **caractérisé par** une plateforme de relais à semi-conducteurs (26) positionnée sur la base (40) adjacente au canal de câble (42), la plateforme de relais à semi-conducteurs (26) étant dimensionnée pour la réception d'un relais à semi-conducteurs (14) ;
et par un couvercle (30) couplé à la base (40) autour du dissipateur thermique (28).

2. Module de relais à semi-conducteurs (22) selon la revendication 1, dans lequel la base (40) est configurée pour le couplage à une paroi (24) de l'enceinte électronique (20) de sorte que le canal de câble (42) s'étend à l'intérieur de l'enceinte électronique (20) et le dissipateur thermique (28) s'étend à l'extérieur de l'enceinte électronique (20) ; et, éventuellement ou de préférence,
comprenant en outre un joint (43) pour le positionnement entre la base (40) et la paroi (24).

3. Module de relais à semi-conducteurs (22) selon la revendication 1, dans lequel la plateforme de relais à semi-conducteurs (26) et le dissipateur thermique (28) sont formés d'un seul tenant sous la forme d'une seule base (40).

4. Système (90) comprenant :
une enceinte électronique (20) ;
le module de relais à semi-conducteurs (22) selon la revendication 1, le module de relais à semi-conducteurs (22) incluant le relais à semi-conducteurs (14) et le câble chauffant (38) ; et
un système de commande configuré pour :
la réception d'un premier signal représentant une température à l'intérieur de l'enceinte électronique,
l'actionnement du relais à semi-conducteurs (14) lorsque la température à l'intérieur de l'enceinte électronique (20) est égale ou supérieure à une première température, et
l'actionnement du câble chauffant (38) lorsque la température à l'intérieur de l'enceinte électronique (20) est inférieure à une seconde température.

5. Système selon la revendication 4, dans lequel le système de commande inclut un dispositif de commande (92) et un thermostat mécanique (96), dans lequel le relais à semi-conducteurs (14) est couplé à une source d'alimentation (94) par l'intermédiaire du thermostat mécanique (96) ; et, éventuellement ou de préférence,
dans lequel le thermostat mécanique (96) connecte l'alimentation provenant de la source d'alimentation (94) au relais à semi-conducteurs (14) lorsque la première température est atteinte.

6. Système selon la revendication 4, dans lequel le système de commande est situé à l'intérieur de l'enceinte électronique (20).

7. Système selon la revendication 4, dans lequel la première température et la seconde température sont égales.

8. Module de relais à semi-conducteurs (22) selon la revendication 1, dans lequel le canal de câble (42) inclut
deux canaux de câble (42) s'étendant à partir du premier côté (46) de la base (40), chacun des deux canaux de câble (42) étant dimensionné pour la réception d'un câble chauffant (38) ; et dans lequel
la plateforme de relais à semi-conducteurs (26) est définie sur la base (40) entre les deux canaux de câble (42).

9. Module de relais à semi-conducteurs (22) selon la revendication 8, dans lequel le couvercle (30) inclut une ouverture ventilée (70), ou dans lequel le couvercle (30) est couplé à la base (40) par l'intermédiaire des éléments de fixation (72) et des entretoises isolées 74.

10. Module de relais à semi-conducteurs (22) selon la revendication 8, dans lequel le couvercle (30) inclut une partie avant (66) et deux extrémités (68) s'étendant perpendiculairement à partir de la partie avant (66) ; et, éventuellement ou de préférence,
dans lequel le couvercle (30) inclut une partie supérieure ouverte et une partie inférieure ouverte.

11. Module de relais à semi-conducteurs (22) selon la revendication 8, dans lequel le dissipateur thermique (28) comprend une pluralité d'ailettes (64) s'étendant à partir du second côté (48) de la base (40).

12. Module de relais à semi-conducteurs (22) selon la revendication 8, dans lequel un seul câble chauffant (38) est acheminé à travers l'ensemble des deux canaux de câble (42).

13. Module de relais à semi-conducteurs (22) selon la revendication 8, dans lequel la base (40) est configurée pour le couplage à une paroi (24) de l'enceinte électronique (20) de sorte que les deux canaux de câble (42) s'étendent à l'intérieur de l'enceinte électronique (20) et le dissipateur thermique (28) s'étend à l'extérieur de l'enceinte électronique (20) ; et, éventuellement ou de préférence,
comprenant en outre un joint (54) pour le positionnement entre la base (40) et la paroi (24).

14. Module de relais à semi-conducteurs (22) selon la revendication 8, dans lequel le câble chauffant (38) est configuré pour le chauffage du relais à semi-conducteurs (14) à une température de fonctionnement de base.
